# EUROPÄISCHE PATENTSCHRIFT

(11) **EP 0 799 329 B1**
(45) Veröffentlichungstag und Bekanntmachung des Hinweises auf die Patenterteilung: **15.12.1999**
(21) Anmeldenummer: 96945493.3
(22) Anmeldetag: 11.10.1996
(51) Int. Cl.: C25D 17/06

(54) **TRANSPORTVORRICHTUNG UND TRANSPORTSYSTEM ZUR VERTIKALEN FÜHRUNG VON PLATTENÄHNLICHEN GEGENSTÄNDEN ZUR CHEMISCHEN ODER ELEKTROLYTISCHEN OBERFLÄCHENBEHANDLUNG**
CONVEYOR DEVICE FOR VERTICALLY GUIDING PLATE-LIKE OBJECTS FOR CHEMICAL OR ELECTROLYTIC SURFACE-TREATMENT
DISPOSITIF DE TRANSPORT POUR GUIDAGE VERTICAL D'OBJETS DE TYPE PLAQUES EN VUE DE TRAITEMENTS DE SURFACES CHIMIQUES OU ELECTROLYTIQUES

(30) Priorität: 26.10.1995 DE 19539868
(43) Veröffentlichungstag der Anmeldung: 08.10.1997
(73) Patentinhaber: Lea Ronal GmbH, 75217 Birkenfeld (DE)
(72) Erfinder: BAYER, Reinhold, 70825 Korntal-Münchingen (DE)
(74) Vertreter: Frank, Gerhard, Dipl.-Phys.
(86) Internationale Anmeldenummer: DE9601940
(87) Internationale Veröffentlichungsnummer: WO9715703

(56) Entgegenhaltungen:
- DE-U- 9 109 067
- US-A- 4 518 187
- PATENT ABSTRACTS OF JAPAN vol. 095, no. 002, 31.März 1995 & JP 06 306691 A (CHUO SEISAKUSHO LTD), 1.November 1994, in der Anmeldung erwähnt

## Beschreibung

### Technisches Gebiet

Die Erfindung betrifft zunächst eine Transportvorrichtung gemäß dem Oberbegriff des Patentanspruchs 1.

### Stand der Technik

Eine Transportvorrichtung der gattungsgemäßen Art ist beispielsweise aus dem JP 06306691 A oder auch der DE 84 22 297 U1 bekannt.

Beim Gegenstand des DE 84 22 297 U1 geht es im wesentlichen darum, eine möglichst weite Öffnung des klammerähnlichen unteren Erfassungsbereichs sicherzustellen, um eine automatische oder robotermäßige Bestückung der Transportvorrichtung mit Leiterplatten zu ermöglichen. Zu diesem Zweck ist ein Schenkel des klammerähnlichen Erfassungsbereichs feststehend ausgebildet, der andere ist an einer Drehscheibe befestigt, die über eine Nockenverbindung von einem vertikal verschiebbaren Element beaufschlagt wird, das bei dieser Ausführungsform von einer federbelasteten Kolbenstange gebildet wird. Bei der Betätigung der Kolbenstange durch eine äußere Kraft, beispielsweise pneumatisch, schwenkt die Drehscheibe den beweglichen Schenkel zur Seite.

Diese Geometrie ist denkbar ungünstig, da infolge des vorgegebenen Hebelverhältnisses zwischen dem Radius der Drehscheibe einerseits und dem Abstand des Erfassungsbereichs für die Leiterplatten vom Drehpunkt der Drehscheibe andererseits nur relativ geringe Haltekräfte auf die Leiterplatten ausgeübt werden können, oder die auch beim Gegenstand dieser Druckschrift angestrebte "besonders gute Klemmwirkung der Zange" nur mit einer sehr hohen Federkraft erreichbar ist, die eine entsprechend aufwendige mechanische Bauweise erfordert und eine sehr hohe Betätigungskraft als Gegenkraft zu dieser Feder zum Öffnung der Klammer.

Bei der Bildung eines Transportsystems mit einer Vielzahl solcher Transportvorrichtungen werden diese mittels eines Bügels an einer Tragschiene angehängt; die hohe Betätigungskraft zum Öffnen der Klammer erfordert dementsprechend aufwendige und mechanisch stabile Betätigungsvorrichtungen an der Tragschiene.

Die JP 06306691 A benutzt einen wippenartigen Mechanismus zur Öffnung und Schließung des klammerähnlichen Erfassungsbereichs, wobei ebenfalls ein feststehender Schenkel und ein darauf wippenähnlich gelagerter Greifschenkel vorgesehen ist. Auf das obere Ende dieses Greifschenkels wirkt über ein aufwendiges Mechanikgestänge die Kolbenstange eines im wesentlichen vertikal gehaltenen Zylinders. Die Haltekraft dieser Klammereinrichtung wird ausschließlich bestimmt durch eine zwischen den beiden oberen Enden der Klammern gehaltene Feder, wobei die erreichbare Haltekraft dieser vorbekannten Vorrichtung durch eine entsprechend gewählte wippenartige Lagerung ein Mehrfaches der Federkraft betragen kann. Zur Öffnung der Klammer muß die Kolbenstange in den Zylinder eingezogen werden und über den Gelenkmechanismus wird dann gegen die Kraft der Feder die Klammerwippe betätigt. Diese recht kompakt ausgebildete Transportvorrichtung hat allerdings den Nachteil vieler Gelenke und Schwenkhebel und ist offenbar zur elektrischen oder pneumatischen Öffnung/Schließung des Erfassungsbereichs gedacht. Zum Einsatz in einem Transportsystem ist diese Vorrichtung zu aufwendig und umständlich.

Eine ähnliche Vorrichtung, die allerdings von vornherein nicht zur Verwendung mit einem Transportsystem zur chemischen oder elektrolytischen Oberflächenbehandlung gedacht ist, zeigt die US 5,102,287; hier sind zwei symmetrisch aufgebaute und wippenartig gehaltene Klammerteile vorgesehen, die an ihren zugewendeten Flächen Steuerkurven aufweisen, die von einem vertikal arbeitenden Stössel beaufschlagt werden, wodurch die Öffnung und die Schließung der beiden Klammern bewirkt werden kann. Durch die Gestaltung dieser Steuerkurven ist es möglich, eine relativ hohe Haltekraft zwischen den Enden der beiden Klammern zu erreichen, wobei allerdings dann auch infolge der ungünstigen Wahl des Hebelarms zwischen Klammerenden einerseits und Kontaktpunkten des Stössels mit den Klammern dieser Stössel mit sehr hohen Kräften beaufschlagt werden muß, was zu einer entsprechend aufwendigen Apparatur führt, wie aus der hochbauenden Bauweise der dort vorgesehenen Zylindervorrichtungen erkennbar ist. Eine solche Lösung ist daher zum Einsatz in Transportsystemen nicht brauchbar.

### Darstellung der Erfindung

Es ist daher Aufgabe der Erfindung, die vorbekannten Transportvorrichtungen so zu verbessern, daß eine sichere und definierte Erfassung der zu bearbeitenden Gegenstände gewährleistet ist, wobei insbesondere auch hohe Haltekräfte erzielbar sein sollen.

Diese Aufgabe wird gemäß dem kennzeichnenden Teil des Patentanspruchs 1 gelöst.

Der Grundgedanke der Erfindung geht also aus von einer einheitlichen Klammervorrichtung, die mit nur einem einzigen Transportband geführt wird und deren Halteelemente sowohl eine im wesentlichen horizontale Öffnungs- und Schließbewegung, als auch eine vertikale Heb- und Senkbewegung gestatten.

Vorteilhafte Ausgestaltungen der erfindungsgemäßen Lösung sind Unteransprüchen zu entnehmen.

### Kurze Beschreibung der Zeichnungen

Ein bevorzugtes Ausführungsbeispiel der erfindungsgemäßen Transportvorrichtung wird nun anhand von Zeichnungen näher erläutert, es zeigen:
- Figur 1A:: Einen Vertikalschnitt durch die Transportvorrichtung in der Transportebene, in der Ebene Z-Z der Figur 1B,
- Figur 1B:: einen Horizontalschnitt durch die Transportvorrichtung in den Ebenen X-X (links) und Y-Y (rechts) der Figur 1A,
- Figur 2:: eine Ansicht der Transportvorrichtung in Transportrichtung, in ihren wesentlichen Positionen,
- Figur 3:: eine schematische Darstellung der Funktion des Gelenkmechanismus in den wesentlichen Positionen, und
- Figur 4:: eine schematische Aufsicht auf das Transportsystem.

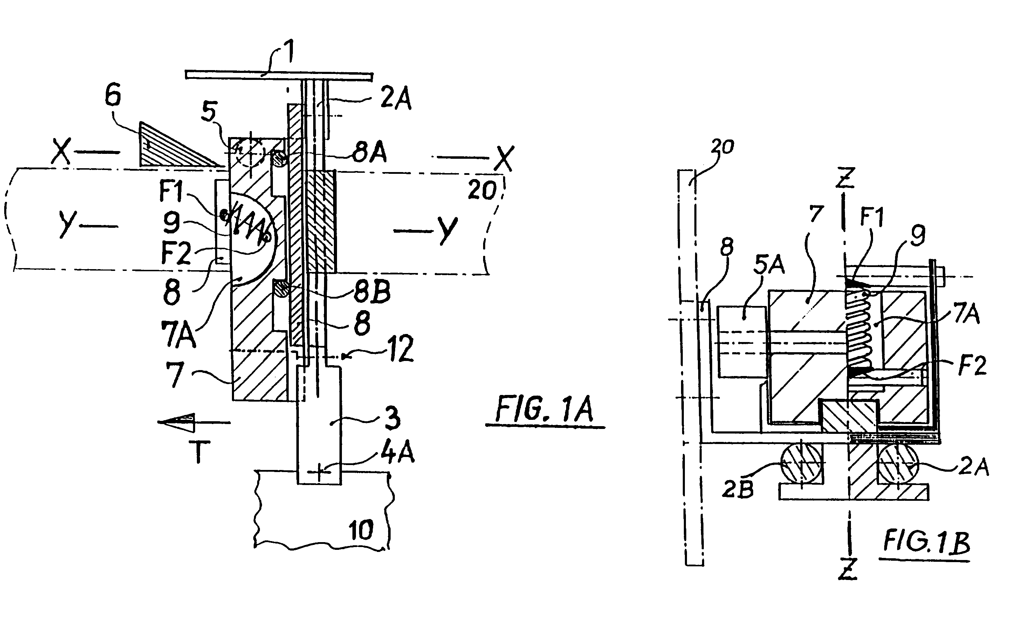

Figur 1A und B zeigen strichpunktiert ein Transportband 20 (oder eine ähnliche Einrichtung), an dem eine Vielzahl von erfindungsgemäßen Transportvorrichtungen gehalten sind, die ihrerseits plattenförmige Gegenstände 10, wie z.B. zu beschichtende Leiterplatten, durch ein Galvanikbad transportieren sollen. Die Transportvorrichtung ist im wesentlichen zangenähnlich oder klammerähnlich aufgebaut:

Zur Halterung dient eine Klammeraufhängung 8, die fest mit dem Transportband 20 verbunden ist. Die Klammeraufhängung 8 umfaßt ihrerseits klammerartig einen Schiebekörper 7, der entlang einer Fläche des Klammerkörpers 8 zwischen zwei Anschlägen 8A,8B in entsprechenden Aussparungen zwischen zwei Höhenpositionen kontinuierlich verschiebbar ist. Auf ihrer einer Innenseite der Klammeraufhängung 8 zugewandten Seite weist der Schiebekörper 7 eine Aussparung 7A auf; an der Innenseite der Klammeraufhängung 8 befindet sich der erste Fußpunkt F1 einer Druckfeder 9, deren zweiter Fußpunkt F2 am Boden der Aussparung 7A verankert ist. Da die Relativposition des Fußpunktes F2 zum stationären Fußpunkt F1 bei einer Verschiebung des Schiebekörpers 7 sich ändert, bewirkt diese Feder 9 ein Verhalten, wie es weiter unten noch näher beschrieben wird.

Der Klammerkörper 8 umfaßt ebenfalls als Stromleitungsteile zwei Klammerteile 2A,2B in ihrem mittleren Bereich, die an ihrem oberen Ende jeweils eine im wesentlichen horizontale Kontaktplatte 1A,1B tragen und an ihrem unteren Ende über eine Gelenkverbindung 12A,12B mit Kontaktschenkeln 3A,3B verbunden sind. Vorzugsweise bestehen die Klammerteile 2A,2B aus mit Kupfer gefüllten Titanrohren, wodurch eine widerstandsarme Übertragung auch hoher Galvanoströme erreicht wird.

Über nicht dargestellte, über den Kontaktplatten und somit in sicherer Distanz zum korrosiven Galvanikbad gehaltene, Kontaktbürsten sind die Kontaktplatten 1A,1B kathodisch gepolt, übertragen den Galvanisierstrom über die Klammerteile 2A,2B auf Kontaktstellen 4A,4B auf den Kontaktschenkeln 3A,3B und beaufschlagen somit das Galvanisiergut 10 mit dem Kathodenstrom.

Die Klammerteile 2A,2B bilden eine im wesentlichen zangenähnliche Struktur, deren horizontale und vertikale Positionierung eindeutig von der Position des Schiebekörpers 7 vorgebbar ist:

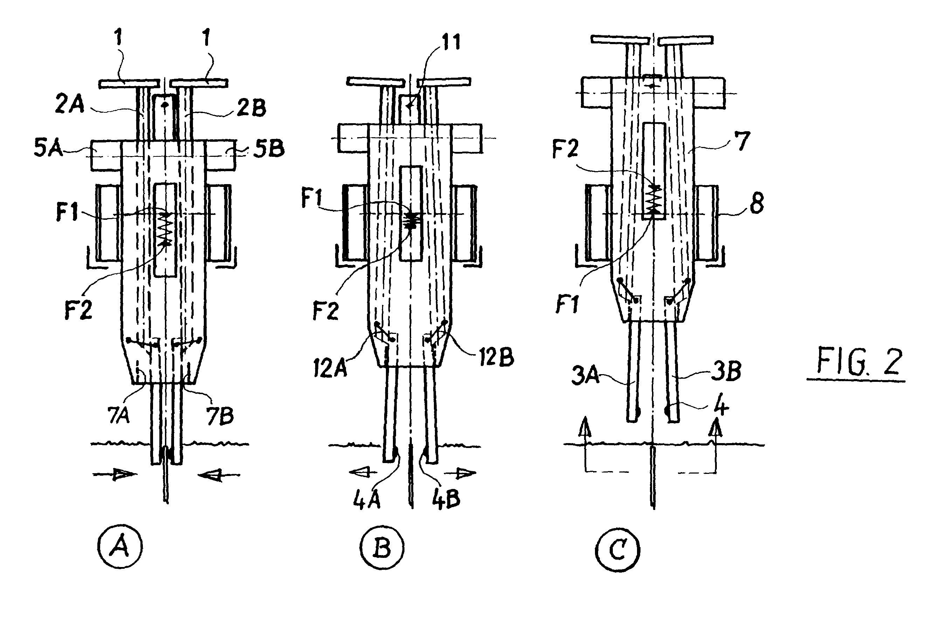

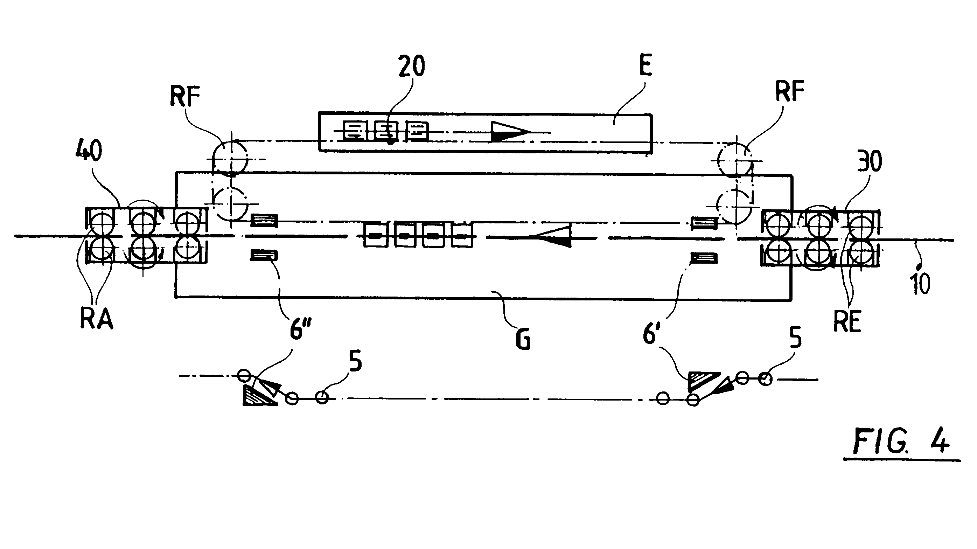

Zu diesem Zweck weist der Schiebekörper 7 beidseitig ein Rollenpaar 5A,5B auf, dessen Rollen eine gemeinsame horizontale Drehachse senkrecht zur Förderrichtung T haben. Zur Zusammenwirkung mit diesem Rollenpaar sind an den geeigneten Stellen, an denen eine Bewegung der Klammer erfolgen soll (beispielsweise zur Erfassung einer Leiterplatte 10), Steuerelemente 6 vorgesehen, die in Figur 1 und 4 schematisch als Keile dargestellt sind. Die Aufgleitfläche dieser Keile befindet sich in der Bewegungsrichtung des Rollenpaares 5A,5B, so daß bei der in Figur 1 und Figur 2 dargestellten Position A ein Transport der Klammer in Transportrichtung T das Rollenpaar 5A,5B zwangsläufig auf die zugeordneten Keile 6 aufgleiten muß.

Der Bewegungsablauf der Klammer wird nun anhand der Figur 2 näher erläutert:

Bei der in Figur 2A dargestellten Positionierung ist der Schiebekörper 7 in seiner tiefsten Position und die von ihm gesteuerte Gelenkverbindung 12 beaufschlagt ihrerseits die Klammerteile 2 derart, daß die beiden Kontaktschenkel 3 beidseitig fest gegen das Galvanisiergut 10 gepreßt werden. Da hierbei der Fußpunkt F2 der Feder 9 unterhalb ihres stationären Fußpunktes F1 an der Klammeraufhängung 8 liegt, wirkt die Dehnkraft oder Spannkraft der Feder 9 folglich kontinuierlich auf den Schiebekörper 7 und die Gelenkverbindung 12, so daß die Kontaktschenkel 3 infolge der hebelarmähnlichen Umsetzung der Federkraft über die Gelenkverbindung 12 sicher geschlossen bleiben und das Galvanisiergut 10 festhalten.

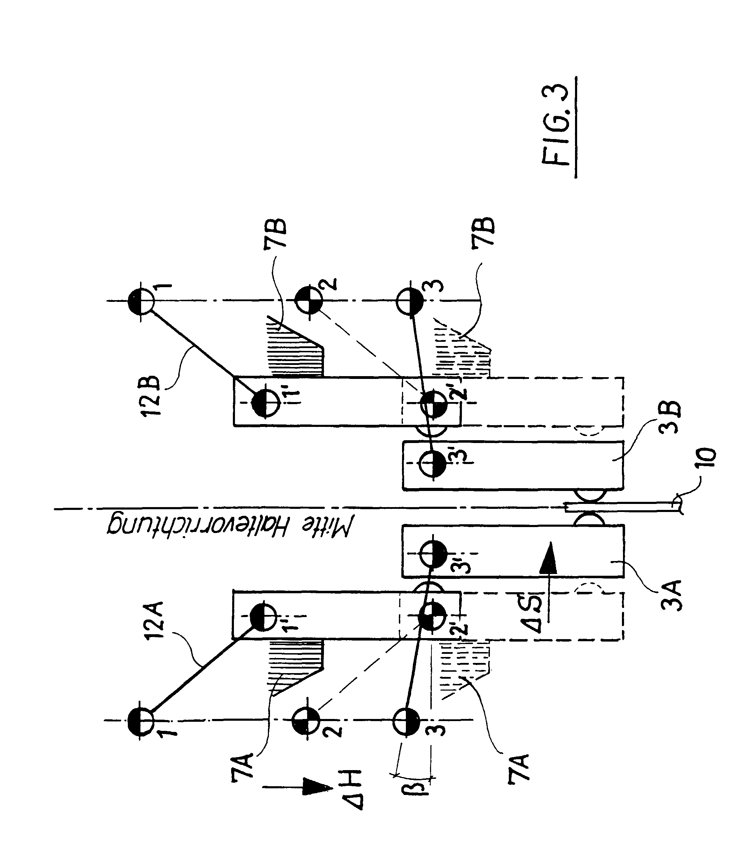

Gleitet nun das Rollenpaar 5A,5B auf die Keile 6 (6" in Fig. 3) auf, so ergibt sich zunächst eine Position wie in Figur 2B dargestellt:

Die Verschiebung des Schiebekörpers 7 nach oben gegen die Spannkraft der Feder 9 bewirkt zunächst, daß über die Gelenkhebel 12A,12B ein seitliches Ausschwenken der Kontaktschenkel 3 bis zu einem Anschlag 7A,7B des Schiebekörpers erfolgt und das Galvanisiergut freigegeben wird. Eine wesentliche Änderung der Vertikalposition der Kontaktschenkel 3 ist hiermit jedoch noch nicht verbunden.

Erst ein weiteres Aufgleiten des Rollenpaares 5A,5B auf die Keile 6 bis zur oberen Endposition des Schiebekörpers 7, wie er in Figur 2C dargestellt ist, führt auch zu einer vertikalen "Mitnahme" der Kontaktschenkel 3 nach oben, was in der Praxis bedeutet, daß die Kontaktstellen 4A,4b aus dem Galvanikbad gehoben werden können, dessen Oberfläche in Figur 2 schematisch dargestellt ist. Damit ist es auch ohne weiteres möglich, daß das Förderband 20 und damit die daran befestigten Klammern über die Begrenzungswandungen des Galvanikbades G geführt werden, nachdem das metallisch beschichtete Galvanisiergut 10 von anderen, nicht dargestellten Transportvorrichtungen erfaßt und aus dem Galvanikbad gefördert wird.

In der in Figur 2C dargestellten, oberen Endposition des Schiebekörpers 7 befindet sich der Fußpunkt F2 oberhalb des stationären Fußpunktes F1, so daß sich die hier entscheidende vertikale Komponente der Spannkraft der Feder 9 gegenüber der in Figur 2A und 2B dargestellten Position des Schiebekörpers 7 nach oben umkehrt, mit der Folge, daß die in Figur 2C dargestellte obere, Freigabeposition der Klammer auch zuverlässig erhalten bleibt, wenn das Rollenpaar 5A,5B die Steuermittel 6 verlassen hat.

Wenn die Klammer wieder nach dem Rücklauf des Transportbandes 20 das Galvanikbad erreicht und in dieses eintauchen und Galvanisiergut 10 ergreifen soll, so laufen die beschriebenen Vorgänge in umgekehrter Reihenfolge ab, wie dies schematisch in Figur 4 angedeutet ist:

Am Beginn des Galvanikbades G wird durch ein entsprechend ausgebildetes und angeordnetes Steuerelement 6' der Schiebekörper 7 gegen die vertikal nach oben gerichtete Spannkraft der Feder 9 wieder nach unten geschoben, worauf zunächst (noch ohne Schließbewegung) die beiden Kontaktschenkel 3A,3B in den Elektrolyten eintauchen und die beiden Kontaktstellen 4A,4B beidseitig des Randes des Galvanisiergutes 10 positioniert werden. Bei der weiteren Verschiebung des Schiebekörpers 7 nach unten ergreifen dann die beiden Kontaktschenkel 3 das Galvanisiergut wieder von beiden Seiten, wobei durch eine entsprechende Verschwenkung der Hebelarme 12A,12B der Gelenkverbindung 12 eine wesentliche "Verstärkung" der Federkraft 9 bzw. deren Umsetzung in eine beidseitige Haltekraft erfolgt.

Die beschriebene Haltevorrichtung ist daher durch zwei wesentliche Funktionsprinzipien gekennzeichnet:

Zum einen dadurch, daß sowohl die Haltekraft für das Galvanisiergut in der unteren, Halteposition, als auch das Gewicht der Klammer in ihrer oberen, Freigabeposition durch eine Richtungsänderung der Spannkraft der Feder 9 erreicht wird, zum anderen dadurch, daß der weitgehend lineare Bewegungsablauf des Schiebekörpers 7 durch die Zwischenschaltung der Gelenkverbindung 12 in zwei aufeinanderfolgende Bewegungsabläufe umgesetzt wird, nämlich in ein im wesentlichen horizontal verlaufendes Spreizen bzw. Auseinanderbewegen der Kontaktschenkel 3 und eine anschließende Vertikalbewegung der Kontaktschenkel nach oben beim Übergang der Kontaktklammer von ihrer Halte- in ihre Freigabeposition bzw. in umgekehrter Reihenfolge beim Übergang von der Freigabeposition in die Halteposition. Beide Endpositionen sind insofern stabil, als sie durch die Spannkraft der Feder 9 gesichert werden. Es ist damit gewährleistet, daß sowohl das Erfassen als auch das Loslassen des Galvanisiergutes durch die erfindungsgemäße Klammer jederzeit sicher und vollständig erfolgt.

Figur 3 zeigt zur Verdeutlichung dieser "Verstärkung" eine schematische Darstellung der Position der beiden Anlenkpunkte der Hebelarme 12A,12B mit der Gelenkverbindung 12:

Die Position (1) mit den Anlenkpunkten 1 am Schiebekörper 7 und 1' am Kontaktschenkel 3A,3B entspricht der Position C der Figur 2; beim Absenken des Schiebekörpers 7 zur Position (2) (entspricht Position B der Figur 2) ändern sich die geometrischen Verhältnisse nicht, der die Anlenkpunkte 2/2' verbindende Hebelarm bleibt in seiner Winkelstellung erhalten, der Verschiebeweg 1-2 des Schiebekörpers 7 wird somit identisch umgesetzt in einen gleich langen Schiebeweg 1'-2' der Kontaktschenkel 3A,3B.

Beim Übergang von der Position (2) in die Position (3) ist die Gelenkverbindung 12 so geführt, daß die Hebelarme 12A,12B nicht mehr vertikal verschoben werden, sondern verschwenken und somit die Schließbewegung der Kontaktschenkel 3A,3B bewirken, an deren Ende das Ergreifen bzw. Halten des Galvanisiergutes 10 steht. Bei der dargestellten Position (3) bei einem Winkel β von etwa 10° bis 20° zwischen der Horizontalen und dem Hebelarm 12A,12B bewirkt eine Verschiebung um ΔH des Schiebekörpers 7 nach unten nur noch eine um einen Faktor von 1/5 kleinere Verschiebung ΔS nach innen. Da dementsprechend das Verhältnis ΔH/ΔS bei etwa 5 liegt, bewirkt jede differenzielle Schiebekraft ΔF auf dem Weg ΔH eine etwa 5-fach höhere Schließ- oder Klemmkraft auf dem Schließweg ΔS.

Figur 4 zeigt schematisch eine Aufsicht auf das Transportband 20 in seiner relativen Positionierung zu dem aus einzelnen Teilen, z.B. Leiterplatten, bestehenden Galvanisiergut 10, das durch das Galvanikbad G transportiert wird. Im Beschichtungsbereich zwischen den Steuerkeilen 6' und 6" (Anodenbereich) halten die Klammern ihre zugeordnete Leiterplatte in der in Figur 2A dargestellten Position, danach erfolgt die Spreizung (Figur 2B) und das Herausheben der Kontaktschenkel (Figur 2C), worauf die Klammern dann mit ihrem Transportband 20 über die Rücklaufstrecke wieder zum Eingang des Galvanikbades transportiert werden; im Bereich der Rücklaufstrecke kann zweckmäßigerweise eine Einrichtung E zum Entmetallisieren der Kontaktstellen 4A,4B vorgesehen sein.

Im stirnseitigen Eingangs- und Ausgangsbereich des Galvanikbades G ist eine Eingangseinheit 30 bzw. eine Ausgangseinheit 40 angeordnet, die beim dargestellten Ausführungsbeispiel drei vertikal liegende Rollenpaare RE (in der Eingangseinheit) bzw. RA (in der Ausgangseinheit) halten. Die beiden Rollen jedes Rollenpaares sind durch geeignete Federeinrichtungen gegeneinander gedrückt, so daß sie zusammen mit schematisch angedeuteten Dichtlippen zumindest den wesentlichen Teil der stirnseitigen Abdichtung des Galvanikbades G übernehmen können, wo die zu beschichtenden Leiterplatten diesem zugeführt bzw. von diesem wieder entnommen werden.

Eine weitere Aufgabe dieser Rollenpaare RE/RA besteht in der aktiven Zuführung bzw. der Abfuhr der zu beschichtenden Gegenstände 10 in den Wirkungsbereich der am Förderband 20 befestigten Transportvorrichtungen und zwar exakt synchronisiert mit der Fördergeschwindigkeit des Förderbandes. Zu diesem Zweck sind die Rollenpaare mit nicht dargestellten Antriebsmitteln verbunden, die zweckmäßigerweise auch den schematisch angedeuteten vier Förderrollen RF des Förderbandes 20 zugeteilt sind. Nach einmaliger Justierung beispielsweise von geeigneten Getriebevorrichtungen ist damit gewährleistet, daß eine exakte Synchronisierung der Fördergeschwindigkeit der zu beschichtenden plattenförmigen Gegenstände 10 mit den Transportvorrichtungen am Förderband 20 im Eingangsbereich und im Ausgangsbereich des Galvanikbades G auf Dauer sichergestellt werden kann. Dies kennzeichnet auch einen weiteren Vorteil dieser Ausgestaltung der erfindungsgemäßen Lösung beispielsweise gegenüber der Lösung nach der gattungsgemäßen DE 39 29 728, wo zur Abdichtung der Stirnseiten des Galvanikbades im Einführ- bzw. Abführbereich der zu beschichtenden Gegenstände Lippendichtungen vorgesehen sind. Derartige Lippendichtungen stellen bei der Synchronisierung der Transportbänder mit geeigneten Zuführ- und Abführvorrichtungen ein störendes Element dar, da ihr Krafteinfluß auf die durchgeförderten Gegenstände nur in gewissen Grenzen abschätzbar und definierbar ist, so daß hier ein Störfaktor gegeben ist, der zu Geschwindigkeitstoleranzen bei der Zuführung der zu beschichtenden Gegenstände führen kann, was zu unerwünschten Relativgeschwindigkeiten zwischen Transportvorrichtungen einerseits und zu beschichtenden, von diesen zu ergreifenden Gegenständen andererseits im Eingangsbereich bzw. unerwünschten Einflüssen und Kraftbeanspruchungen der Transportvorrichtungen im Ausgangsbereich führen kann. Dadurch, daß die Rollenpaare bei der erfindungsgemäßen Ausgestaltung selbst die wesentlichen Dichtfunktionen übernehmen und die Zuführgeschwindigkeit bzw. die Abführgeschwindigkeit selbst definieren, können Relativgeschwindigkeiten zwischen Förderband und zu beschichtenden Gegenständen zumindest minimiert werden.

Beim vorstehend erläuterten Ausführungsbeispiel handelte es sich bei der Oberflächenbehandlung der Gegenstände um deren Beschichtung in einem Galvanikbad. Es versteht sich von selbst, daß Aufbau und Funktionsweise der erfindungsgemäßen Vorrichtung unabhängig von der Wirkungsweise und dem Ergebnis des jeweiligen Bades sind. Die erfindungsgemäßen Transportvorrichtungen sind daher überall dort einsetzbar, wo es um eine chemische oder elektrolytische Oberflächenbehandlung geht, wie z.B. vor oder nach der eigentlichen Galvanisierung.

## Patentansprüche

1. Transportvorrichtung zur Förderung von vertikal orientierten plattenähnlichen Gegenständen zu deren chemischen oder elektrolytischen Oberflächenbehandlung, mit einem klammerähnlichen unteren Erfassungsbereich, mit dem diese Gegenstände aufnehmbar sind, und der mittels eines zumindest im wesentlichen vertikal zwischen zwei Endpositionen verschiebbaren Elementes betätigbar ist,
dadurch gekennzeichnet, daß zangenähnlich gehaltene Klammerteile (2A,2B) an ihrem unteren Ende Kontaktschenkel (3A,3B) als Erfassungsbereich aufweisen, die zur Erfassung und Freigabe eines plattenähnlichen Gegenstandes (10) mittels des in einer Klammeraufhängung (8) gehaltenen Schiebekörpers (7) über eine Gelenkverbindung (12) betätigbar sind, die aus je einem Gelenkarm (12A,12B) besteht, der einerseits am unteren Ende des Schiebekörpers (7) und andererseits am oberen Ende der Kontaktschenkel (3A,3B) angelenkt ist, und daß Geometrie, Führung und/oder Anlenkpunkte der Gelenkarme (12A,12B) so gewählt sind, daß eine Umsetzung der Betätigungskraft des Schiebekörpers (7) derart auf die Kontaktschenkel (3A,3B) erfolgt, daß deren Schließkraft über der Betätigungskraft des Schiebekörpers (7) liegt, und daß der Bewegungsablauf des Schiebekörpers (7) in zwei aufeinanderfolgende Bewegungsabläufe der Kontaktschenkel (3) umgesetzt wird, nämlich in eine im wesentlichen horizontal verlaufende Spreiz- oder Klammerbewegung und eine im wesentlichen vertikal verlaufende Hub- oder Senkbewegung beim Übergang von der Halte- zur Freigabeposition bzw. umgekehrt.

2. Transportvorrichtung nach Anspruch 1, dadurch gekennzeichnet, daß die Betätigungskraft des Schiebekörpers (7) zumindest in der Halteposition der Kontaktschenkel (3A,3B) von einer Druckfeder (9) aufgebracht wird, die zwischen einem ersten Fußpunkt (F1) an der Klammeraufhängung (8) und einem zweiten Fußpunkt (F2) am Schiebekörper (7) derart gehalten ist, daß eine vertikale Komponente der Federkraft den Schiebekörper (7) beaufschlagt.

3. Transportvorrichtung nach Anspruch 2, dadurch gekennzeichnet, daß in der unteren Position des Schiebekörpers (7) (Halteposition) der Fußpunkt (F1) an der Klammeraufhängung (8) über dem Fußpunkt (F2) am Schiebekörper (7) liegt, und daß in der oberen Position des Schiebekörpers (7) (Freigabeposition) der Fußpunkt (F1) unter dem Fußpunkt (F2) liegt, so daß auch in der Freigabeposition das Gewicht der Klammerteile von der Vertikalkomponente der Federkraft aufgenommen wird.

4. Transportvorrichtung nach Anspruch 1, dadurch gekennzeichnet, daß die Klammerteile (2A,2B) als Stromleitungsteile ausgebildet sind, so daß die Übertragung des Galvanostroms von Kontaktplatten (1A,1B) am oberen Ende der Klammerteile (2A,2B) über die Gelenkarme (12A,12B) unmittelbar auf Kontaktstellen (4A,4B) auf den Kontaktschenkeln (3A,3B) erfolgt.

5. Transportvorrichtung nach Anspruch 1, dadurch gekennzeichnet, daß die Gelenkarme (12A,12B) S-förmig abgekröpft sind.

6. Transportsystem mit mehreren Transportvorrichtungen nach einem der vorhergehenden Ansprüche, die umlaufend und synchron mit der Fördergeschwindigkeit der plattenähnlichen Gegenstände bewegt werden und in vorgegebenen Bereichen, beispielsweise eines Galvanikbads diese erfassen und halten,
dadurch gekennzeichnet, daß die Transportvorrichtungen über ihre Klammeraufhängung (8) an einem Förderband (20) gehalten sind, und daß miteinander wechselwirkende Steuermittel im Bereich des Förderwegs einerseits und am Schiebekörper (7) andererseits angeordnet sind, mit denen dessen Vertikalbewegung zwischen der Halteposition und der Freigabeposition steuerbar ist.

7. Transportsystem nach Anspruch 6, dadurch gekennzeichnet, daß die schiebekörperseitigen Steuermittel aus einem beidseitig gehaltenen Rollenpaar (5A,5B) bestehen, und daß die wechselwirkenden Steuermittel aus keilähnlichen Elementen (6) im Förderweg des Rollenpaares (5A,5B) bestehen, mittels denen der Schiebekörper (7) zumindest so weit vertikal verschiebbar ist, daß sich die vertikale Komponente der Kraft der Feder (9) umkehrt.

8. Transportsystem nach Anspruch 6, dadurch gekennzeichnet, daß das Förderband (20) mit den Transportvorrichtungen synchronisiert angetrieben wird, mit vertikal angeordneten Rollenpaaren (RE,RA), die eingangsseitig des Galvanikbades (G) die zu beschichtenden plattenförmigen Gegenstände (10) zwischen sich erfassen und im Galvanikbad an die Transportvorrichtung übergeben, bzw. ausgangsseitig des Galvanikbades diese von den Transportvorrichtungen übernehmen.

9. Transportsystem nach Anspruch 8, dadurch gekennzeichnet, daß mehrere Rollenpaare (RE,RA) Bestandteil einer Eingangs- bzw. Ausgangseinheit (30,40) sind, die an den Stirnseiten des Galvanikbades (G) angeordnet sind.

10. Transportsystem nach Anspruch 8 oder 9, dadurch gekennzeichnet, daß zumindest eine Rolle jedes Rollenpaares derart federnd gehalten ist, daß die Rollen jedes Rollenpaares gegeneinander drücken und das Galvanikbad (G) stirnseitig im Durchtrittsbereich der plattenförmigen Gegenstände (10) zumindest weitgehend abdichten.

11. Transportsystem nach Anspruch 6, dadurch gekennzeichnet, daß im Rücklauf der Transportvorrichtungen diese durch eine rinnenförmige Entmetallisierungsvorrichtung (E) geführt werden, in der ein geeigneter Elektrolyt in den Bereich der Kontaktstellen (4A,4B) gefördert wird.

## Claims

1. Conveying apparatus for conveying vertically orientated, plate-like objects for them to be chemically or electrolytically surface-treated, said apparatus having a clamp-like lower grasping region, by means of which these objects can be picked-up, and which is actuatable by means of an element which is displaceable, at least substantially vertically, between two end positions, characterised in that clamping parts (2A,2B), which are retained in a pincer-like manner, have at their lower end contact portions (3A,3B) as the grasping region, which portions are actuatable by means of sliding member (7), retained in a clamping suspension system (8), via a pivotal connection (12), in order to grasp and release a plate-like object (10), said connection comprising a respective pivotal arm (12A,12B) which, on the one hand, is pivotally mounted on the lower end of the sliding member (7) and, on the other hand, is pivotally mounted on the upper end of the contact portions (3A,3B), and in that geometry, guidance and/or pivot points of the pivotal arms (12A,12B) are so selected that the actuation force of the sliding member (7) is transposed to the contact portions (3A,3B) in such a manner that their closing force is greater than the actuation force of the sliding member (7), and in that the sequence of movement of the sliding member (7) is converted into two successive sequences of movement of the contact portions (3), namely into a substantially horizontally extending spreading or clamping movement and into a substantially vertically extending raising or lowering movement during the transition from the retaining position to the release position, or vice versa.

2. Conveying apparatus according to claim 1, characterised in that the actuation force of the sliding member (7), at least when the contact portions (3A,3B) are in the retaining position, is applied by a compression spring (9) which is retained between a first bottom point (F1) on the clamping suspension system (8) and a second bottom point (F2) on the sliding member (7) in such a manner that a vertical component of the resilient force acts on the sliding member (7).

3. Conveying apparatus according to claim 2, characterised in that, in the lower position of the sliding member (7) (retaining position), the bottom point (F1) on the clamping suspension system (8) lies above the bottom point (F2) on the sliding member (7), and in that, in the upper position of the sliding member (7) (release position), the bottom point (F1) lies beneath the bottom point (F2) so that, even in the release position, the weight of the clamping parts is absorbed by the vertical component of the resilient force.

4. Conveying apparatus according to claim 1, characterised in that the clamping parts (2A,2B) are configured for current conduction, so that the electroplating current is transferred from contact plates (lA,lB) at the upper end of the clamping parts (2A,2B) via the pivotal arms (12A,12B) directly to contact points (4A,4B) on the contact portions (3A,3B).

5. Conveying apparatus according to claim 1, characterised in that the pivotal arms (12A,12B) are bent in an S-shaped manner.

6. Conveying system, having a plurality of conveying apparatus according to one of the preceding claims, which apparatus are moved circumferentially and synchronously at the speed of conveyance of the plate-like objects and grasp and retain said objects in prescribed regions, of an electroplating bath for example, characterised in that the conveying apparatuses are retained on a conveyor belt (20) via their clamping suspension system (8), and in that interacting control means are disposed in the region of the path of conveyance, on the one hand, and on the sliding member (7), on the other hand, the vertical movement of said sliding member between the retaining position and the release position being controllable by said control means.

7. Conveying system according to claim 6, characterised in that the control means on the sliding member side comprise a pair of rollers (5A,5B), which are retained at both ends, and in that the interacting control means comprise wedge-like elements (6) in the path of conveyance of the pair of rollers (5A,5B), by means of which elements the sliding member (7) is vertically displaceable, at least to such an extent that the vertical component of the force of the spring (9) is reversed.

8. Conveying system according to claim 6, characterised in that the conveyor belt (20) is driven, in synchronism with the conveying apparatuses, by means of vertically disposed pairs of rollers (RE,RA) which, at the input end of the electroplating bath (G), grasp therebetween the plate-like objects (10) to be coated and transfer them in the electroplating bath to the conveying apparatus, or respectively transfer them from the conveying apparatuses at the output end of the electroplating bath.

9. Conveying system according to claim 8, characterised in that a plurality of pairs of rollers (RE,RA) are a component part of an input and/or output unit (30,40), which are disposed on the end faces of the electroplating bath (G).

10. Conveying system according to claim 8 or 9, characterised in that at least one roller of each pair of rollers is resiliently retained in such a manner that the rollers of each pair of rollers press against each other, and seal, at least largely, the end faces of the electroplating bath (G) in the transit region of the plate-like objects (10).

11. Conveying system according to claim 6, characterised in that, during the return movement of the conveying apparatuses, the latter are guided through a groove-like deplating apparatus (E), in which a suitable electrolyte is conveyed into the region of the contact locations (4A,4B).

## Revendications

1. Dispositif de transport d'objets du genre plaque orientés verticalement pour le traitement de surface chimique ou électrolytique de ceux-ci, comportant une zone inférieure de saisie du genre pince qui prend ces objets et est manoeuvrée au moyen d'un élément mobile au moins sensiblement verticalement entre deux positions extrêmes, caractérisé par le fait que des éléments formant pince (2A, 2B) présentent à leur extrémité inférieure des branches de contact (3A, 3B) qui forment la zone de saisie et, pour la saisie et la libération d'un objet du genre plaque (10), sont manoeuvrées au moyen d'un corps coulissant (7) monté dans une suspension de pince (8), par l'intermédiaire d'articulations (12) constituées de bras articulés (12A, 12B) qui sont articulés d'une part à l'extrémité inférieure du corps coulissant (7) et d'autre part à l'extrémité supérieure des branches de contact (3A, 3B), et que la forme, le guidage et/ou les points d'articulation des bras articulés (12A, 12B) sont choisis de façon que la force de manoeuvre du corps coulissant (7) soit transmise aux branches de contact (3A, 3B) de façon telle que la force de fermeture de celles-ci soit supérieure à la force de manoeuvre du corps coulissant (7), et que le mouvement du corps coulissant (7) est transformé en deux mouvements successifs des branches de contact (3), à savoir un mouvement sensiblement horizontal d'écartement ou de pincement et un mouvement sensiblement vertical de montée ou de descente lors du passage de la position de maintien à la position de libération ou inversement.

2. Dispositif de transport selon la revendication 1, caractérisé par le fait que la force de manoeuvre du corps coulissant (7) est, au moins dans la position de maintien des branches de contact (3A, 3B), appliquée par un ressort de compression (9) qui est monté entre un premier pied (F1) situé sur la suspension de pince (8) et un deuxième pied (F2) situé sur le corps coulissant (7) de façon telle qu'une composante verticale de la force du ressort agisse sur le corps coulissant (7).

3. Dispositif de transport selon la revendication 2, caractérisé par le fait que, dans la position inférieure du corps coulissant (7) (position de maintien), le pied (F1) situé sur la suspension de pince (8) se trouve au-dessus du pied (F2) situé sur le corps coulissant (7), et que, dans la position supérieure du corps coulissant (7) (position de libération), le pied (F1) se trouve au-dessous du pied (F2), de sorte que dans la position de libération aussi, le poids des éléments formant pince est absorbé par la composante verticale de la force du ressort.

4. Dispositif de transport selon la revendication 1, caractérisé par le fait que les éléments formant pince (2A, 2B) sont des éléments de conduction de courant, de sorte que le courant d'électrolyse est transmis de plaques de contact (1A, 1B) situées à l'extrémité supérieure des éléments formant pince (2A, 2B), par les bras articulés (12A, 12B), directement à des points de contact (4A, 4B) situés sur les branches de contact (3A, 3B).

5. Dispositif de transport selon la revendication 1, caractérisé par le fait que les bras articulés (12A, 12B) sont coudés en forme de S.

6. Système de transport comportant plusieurs dispositifs de transport selon l'une des revendications précédentes, qui sont mus en rond et en synchronisme à la vitesse de transport des objets du genre plaque et saisissent et tiennent ceux-ci dans des zones déterminées par exemple d'un bain d'électrolyse, caractérisé par le fait que les dispositifs de transport sont montés par leur suspension de pince (8) sur une bande transporteuse (20), et que des moyens de commande interactifs sont placés d'une part dans la zone de la voie de transport et d'autre part sur le corps coulissant (7) et commandent le mouvement vertical de ce dernier entre sa position de maintien et sa position de libération.

7. Système de transport selon la revendication 6, caractérisé par le fait que les moyens de commande placés sur le corps coulissant sont constitués d'une paire de rouleaux (5A, 5B) montée des deux côtés, et que les moyens de commande interactifs sont constitués d'éléments du genre coin (6) placés sur le chemin de la paire de rouleaux (5A, 5B) et au moyen desquels le corps coulissant (7) peut être déplacé verticalement au moins jusqu'à ce que la composante verticale de la force du ressort (9) s'inverse.

8. Système de transport selon la revendication 6, caractérisé par le fait que la bande transporteuse (20) est entraînée en synchronisme avec les dispositifs de transport, avec des paires de rouleaux placées verticalement (RE, RA) qui, du côté entrée du bain d'électrolyse (G), saisissent entre elles les objets en forme de plaque (10) à revêtir et les transmettent dans le bain d'électrolyse au dispositif de transport, et, du côté sortie du bain d'électrolyse, les reprennent aux dispositifs de transport.

9. Système de transport selon la revendication 8, caractérisé par le fait que plusieurs paires de rouleaux (RE, RA) font partie respectivement d'un dispositif d'entrée (30) et d'un dispositif de sortie (40) qui sont placés sur les côtés frontaux du bain d'électrolyse (G).

10. Système de transport selon l'une des revendications 8 et 9, caractérisé par le fait qu'au moins un rouleau de chaque paire de rouleaux est monté élastiquement de façon telle que les rouleaux de chaque paire soient serrés l'un contre l'autre et rendent le bain d'électrolyse (G) au moins à peu près étanche frontalement dans la zone de passage des objets en forme de plaque (10).

11. Système de transport selon la revendication 6, caractérisé par le fait que les dispositifs de transport, lors de leur retour, passent dans un dispositif de démétallisation en forme de gouttière (E) dans lequel un électrolyte approprié est amené dans la zone des points de contact (4A, 4B).
